Europäisches Patentamt

European Patent Office

Office européen des brevets

(19)

(11) Numéro de publication: **0 209 469**

**B1**

(12) **FASCICULE DE BREVET EUROPEEN**

(45) Date de publication du fascicule du brevet: **24.10.90**

(51) Int. Cl.⁵: **H 05 H 1/18,** H 05 H 1/46

(21) Numéro de dépôt: **86420145.4**

(22) Date de dépôt: **03.06.86**

(54) Procédé et dispositif d'excitation d'un plasma par micro-ondes à la résonance cyclotronique électronique.

(30) Priorité: **07.06.85 FR 8508836**

(43) Date de publication de la demande:
**21.01.87 Bulletin 87/04**

(45) Mention de la délivrance du brevet:
**24.10.90 Bulletin 90/43**

(84) Etats contractants désignés:
**CH DE GB IT LI NL**

(56) Documents cités:
**EP-A-0 129 490**
**FR-A-2 551 302**

**REVIEW OF SCIENTIFIC INSTRUMENTS, vol. 48, no. 7, juillet 1977, pages 762-766, American Institute of Physics, New York, US; N. SAKUDO et al.: "Microwave ion source"**

**APPLIED PHYSICS LETTERS, vol. 45, no. 2, 15 juillet 1984, pages 132-134, American Institute of Physics, New York, US; Y.ARNAL et al.: "Plasma etching in magnetic multipole microwave discharge"**

(73) Titulaire: **ETAT FRANCAIS représenté par le Ministre des PTT (Centre National d'Etudes des Télécommunications)**
**38-40 rue du Général Leclerc**
**F-92131 Issy-les-Moulineaux (FR)**
(73) Titulaire: **CENTRE NATIONAL DE LA RECHERCHE SCIENTIFIQUE (CNRS)**
**13 Quai Anatole France**
**F-75700 Paris (FR)**

(72) Inventeur: **Pichot, Michel**
**11, Chemin du Couvent**
**F-38100 Grenoble (FR)**
Inventeur: **Pelletier, Jacques**
**Le Murier**
**F-38400 Saint Martin d'Heres (FR)**
Inventeur: **Arnal, Yves**
**5, rue Théodore Dubois**
**Poizat F-38230 Eybens (FR)**

(74) Mandataire: **Ropital-Bonvarlet, Claude et al**
**Cabinet BEAU DE LOMENIE, 51, avenue Jean-Jaurès**
**F-69007 Lyon (FR)**

**EP  0 209 469  B1**

(56) Documents cités:

"Fachlexikon ABC Physik",vol.2:M-Z,R.Leak et
W.Gellert,(1974),pages 1175-1176 et 1771-1772
Encyclopedia of Science and Technology,Mc
Graw-Hill,(1977),vol.10,pages 450-455

## Description

La présente invention a pour objet un procédé et un dispositif d'excitation d'un plasma par micro-ondes, à la résonance cyclotronique électronique, pour la production d'un plasma dense, homogène et de grand volume.

La production de plasma peut être utilisée en vue d'applications très diverses, telles que les traitements de surface, ou la production de faisceaux d'ions.

La plupart des techniques d'excitation plasma mises en oeuvre dans les laboratoires et pour les applications industrielles font appel à des décharges continues ou des décharges radiofréquences dont le couplage est généralement capacitif.

Pour le domaine plus particulier des microondes, on connaît divers dispositifs d'excitation.

Selon un premier type de dispositifs d'excitation, on utilise un couplage dans une cavité micro-ondes, ce qui permet d'obtenir des plasmas à relativement forte pression ($10^{-1}$ à $10^2$ Pascals) et confinés dans des volumes de faibles dimensions.

Selon un deuxième type de dispositifs d'excitation, on réalise un couplage par onde de surface (surfatron, surfaguide). Dans ce cas, le domaine de pression accessible est vaste ($10^{-1}$ à quelques $10^5$ Pascals). On obtient, généralement, dans ce cas, des colonnes de plasma de faible diamètre.

L'excitation du plasma peut encore s'effectuer par couplage en champ magnétique à la fréquence de résonance cyclotronique électronique. Dans ce cas, la résonance est obtenue pour un champ magnétique B et une fréquence d'excitation f, liés par la relation:

$$(I) \qquad B = \frac{2\pi m}{e} \times f$$

où m et e sont la masse et la charge de l'électron. A titre d'exemple, pour une fréquence de 2,45 GHz, il est nécessaire d'utiliser un champ magnétique de 875 Gauss pour obtenir la résonance.

Avec un tel type d'excitation, il est possible d'obtenir des plasmas à très basse pression, de l'ordre de $10^{-2}$ Pascals.

On a également réalisé une excitation du plasma à l'aide d'une antenne dite "de Lisitano". Le plasma peut s'allumer si l'antenne est plongée dans un champ magnétique uniforme suffisant pour obtenir la résonance cyclotronique électronique.

Les différents dispositifs d'excitation mentionnés ci-dessus présentent tous un certain nombre de difficultés d'adaptation, en vue de leur application à certains dispositifs, notamment lorsqu'il est nécessaire de disposer de grands volumes de plasma homogène et dense dans une large plage de pression. De telles exigences existent, en particulier, pour les traitements de surfaces par plasma, tant en métallurgie qu'en micro-électronique, pour les opérations de dépôt, gravure, excitation.

On a déjà proposé, dans la demande de brevet EP-A-0 129 490, de réaliser un confinement magnétique multipolaire et d'utiliser une source micro-ondes localisée, afin de permettre l'obtention de plasma d'une bonne homogénéité. Un tel dispositif nécessite, toutefois, que le libre parcours moyen des ions soit de l'ordre de grandeur, voire plus grand que les dimensions du plasma. Ceci impose de travailler à basse pression, de l'ordre de $10^{-1}$ à $10^{-3}$ Pascals. On utilise donc la résonance cyclotronique électronique pour exciter de tels plasmas. Une limitation importante est, cependant, la densité de plasma que l'on peut obtenir dans un tel dispositif. En effet, l'augmentation de la densité du plasma implique, soit une augmentation de la surface de la source micro-ondes, soit une augmentation du nombre de sources.

Or, la mise en oeuvre de ces deux solutions se heurte au problème de la production d'un grand volume de champ magnétique à l'aide de bobines. Outre le coût de l'alimentation électrique, une limitation est constituée par le fait que la présence de champs magnétiques de fuite élevés, loin de la bobine, rendent le plasma anisotrope. En outre, il est nécessaire d'introduire la puissance électrique micro-onde sous vide par des fenêtres en matériaux diélectriques, tels que du quartz, de l'alumine, ce qui pose des problèmes technologiques pour certaines applications. Enfin, la présence d'une puissance micro-onde résiduelle dans le plasma peut s'avérer gênante pour certains procédés, tels que la gravure avec des masques de résines par exemple.

Il n'est pas non plus possible d'augmenter la densité de la source par augmentation de la fréquence micro-onde. En effet, dans ce cas, le champ magnétique nécessaire à la résonance est également fortement augmenté, ce qui amplifie les contraintes mentionnées précédemment. De plus, aux fréquences élevées en mode fondamental, le gain est diminué, comme l'est la surface de la section droite du guide d'ondes.

La présente invention a pour objet de remédier aux inconvénients précédents et de permettre la production d'un plasma, à partir d'une excitation micro-onde, dans des conditions telles que le plasma soit de grand volume, de bonne homogénéité, de basse pression, de densité élevée, isotrope, c'est-à-dire exempt de champs magnétiques statiques et électromagnétiques périodiques dans la zone d'utilisation et possède une indépendance entre les paramètres de génération du plasma et ceux d'intéraction de ce dernier avec le substrat à traiter.

La présente invention a ainsi pour objet la création d'un volume central de plasma dépourvu de champ magnétique et d'énergie micro-onde en volume.

Selon l'invention, un dispositif d'excitation de plasma par micro-ondes à la résonance cyclotronique électronique, comportant au moins un aimant permanent, est caractérisé en ce que l'aimant permanent crée une surface à champ magnétique constant d'intensité correspondant à la résonance cyclotronique électronique et en ce qu'il comporte au moins une antenne raccordée à une structure coaxiale d'application d'énergie dans le domaine des micro-ondes et positionnée au moins à proximité de ladite surface à champ magnétique constant d'intensité correspondant à la résonance cyclotronique électronique.

Avantageusement, l'aimant permanent est constitué par une barre aimantée et l'antenne est positionnée à l'intersection du plan médian de ladite barre et de la surface à champ magnétique constant et d'intensité correspondant à la résonance cyclotronique électronique.

La structure coaxiale peut être constituée par un câble coaxial.

Le dispositif d'excitation peut comprendre, en outre, des moyens de circulation d'un fluide de refroidissement le long de l'antenne.

Par ailleurs, des moyens d'amenée de gaz à ioniser peuvent être disposés à proximité immédiate de l'antenne et percés d'orifices répartis le long de ladite antenne.

L'invention concerne, plus particulièrement, un dispositif de production d'un plasma dense, de grand volume et de bonne homogénéité, comprenant une enceinte étanche raccordée à un circuit de pompage et à un circuit d'apport d'un milieu gazeux pour maintenir une pression déterminée dans l'enceinte, une structure de confinement magnétique multipolaire et un dispositif d'excitation par micro-ondes du milieu gazeux à la résonance cyclotronique électronique, caractérisé en ce que le dispositif d'excitation par micro-ondes comprend, au moins, une structure coaxiale pour l'introduction de la puissance micro-ondes à l'intérieur de la structure de confinement multipolaire et, au moins, une antenne couplée à la structure coaxiale pour l'introduction localisée de l'énergie micro-ondes, en ce que la structure de confinement magnétique multipolaire comprend une série d'aimants permanents créant un réseau de surfaces à champ magnétique constant et présentant, localement, une intensité correspondant à la résonance cyclotronique électronique et en ce que ladite antenne est positionnée sur ledit réseau de surface à champ magnétique constant dans une zone d'intensité correspondant à la résonance cyclotronique électronique.

Dans ce cas, le champ magnétique de type multipolaire permanent est utilisé, à la fois pour le confinement et pour la création de plasma.

Selon un mode de réalisation particulier, la structure de confinement magnétique multipolaire est constituée par une cage multipolaire formée par des barres, à caractère magnétique permanent s'étendant parallèlement entre elles et offrant, en direction du volume que la structure de confinement délimite, une face de polarités successivement différentes et l'antenne est disposée parallèlement à une barre magnétique, à l'intersection du plan médian de la barre et de la surface d'un champ magnétique constant et d'intensité correspondant à la résonance cyclotronique électronique.

Le dispositif d'excitation par micro-ondes peut comprendre plusieurs antennes réparties le long de la structure de confinement magnétique multipolaire.

La structure de confinement magnétique multipolaire, formant cage, peut être associée à une structure de fermeture du circuit magnétique à l'extérieur de la cage, laquelle structure de fermeture peut comprendre des aimants permanents ou un matériau de grande perméabilité. La structure ainsi réalisée peut être, en tout ou partie, à l'intérieur ou à l'extérieur de l'enceinte étanche.

Selon une caractéristique particulière de l'invention, au moins un tube d'introduction du gaz à ioniser est situé au voisinage immédiat de chaque antenne, parallèlement à celle-ci, et chaque tube est percé d'un ensemble d'orifices répartis sur sa longueur et présentant un diamètre faible par rapport au diamètre du tube.

L'invention a encore pour objet un procédé d'excitation d'un plasma par micro-ondes à la résonance cyclotronique électronique, pour la production d'un plasma dense, de grand volume, de bonne homogénéité et isotrope, caractérisé en ce qu'il consiste à produire localement, à l'aide d'une structure magnétique multipolaire, un champ magnétique d'intensité suffisante pour la résonance cyclotronique électronique et à introduire, à l'aide d'antennes, l'énergie micro-ondes, de façon localisée, dans la zone de champs magnétiques permettant une résonance cyclotronique électronique.

D'autres caractéristiques et avantages de l'invention ressortiront de la description suivante des modes particuliers de réalisation en référence aux dessins annexés sur lesquels:

la fig. 1 est une vue schématique en coupe selon un plan radial d'un dispositif de production de plasma selon l'invention,

la fig. 2 est une vue schématique de côté, montrant un dispositif élémentaire d'excitation selon l'invention,

les fig. 3a et 3b représentent deux variantes de réalisation du dispositif élémentaire de la fig. 2, en section selon un plan radial,

la fig. 4 montre, de façon schématique, en coupe radiale l'ensemble d'un dispositif de production de plasma selon l'invention, et,

la fig. 5 représente en perspective, avec arrachement, un dispositif d'excitation de plasma comprenant une cage de confinement magnétique multipolaire et une antenne d'excitation micro-ondes localisée.

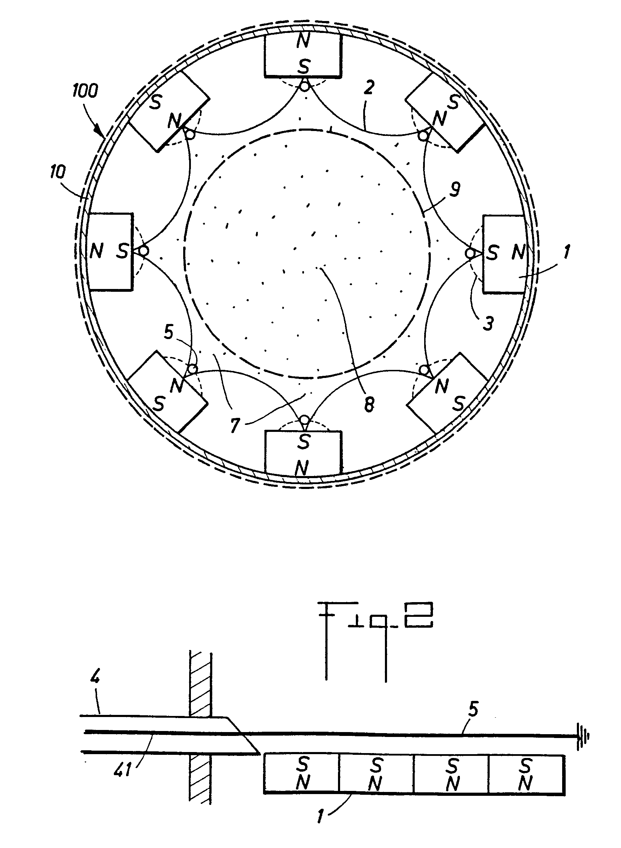

Si l'on se reporte aux fig. 1, 4 et 5, on voit une structure magnétique multipolaire 100, formant cage, constituée d'aimants permanents 1 assurant le confinement du plasma dans une zone centrale 8. La structure magnétique multipolaire 100 est réalisée de telle manière que l'on obtient localement un champ magnétique d'intensité suffisante pour la résonance cyclotronique électronique. Par exemple, pour une fréquence d'excitation de 2,45 GHz, le champ magnétique doit être de 875 Gauss et pour une fréquence d'excitation de 10 GHz, l'intensité du champ magnétique doit être de 3 500 Gauss. L'énergie micro-ondes est introduite dans la cage multipolaire 100, non en volume, mais de façon localisée dans la zone de champ magnétique permettant la résonance, à l'aide d'au moins une antenne 5 située au voisinage de la surface de confinement 2.

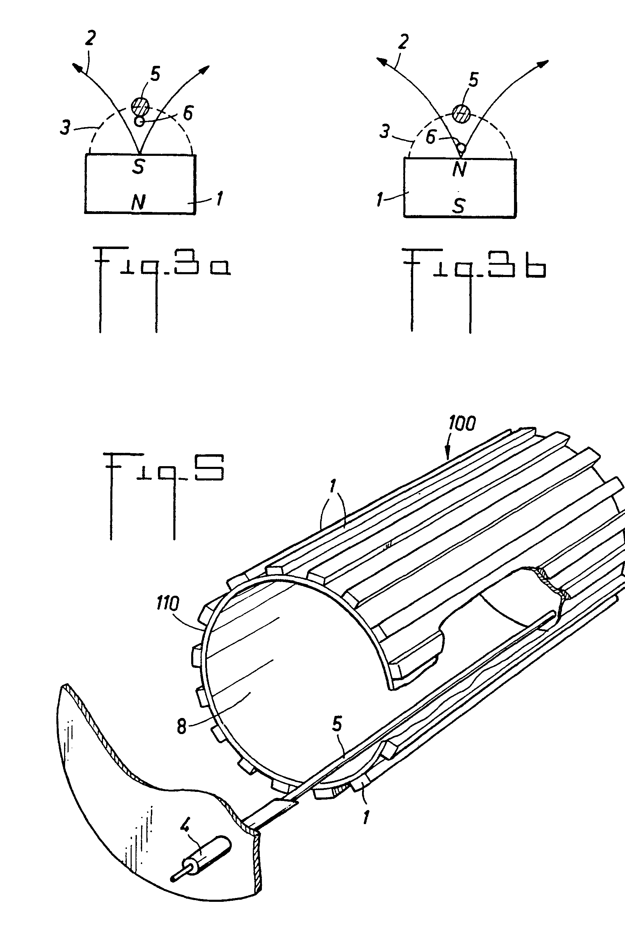

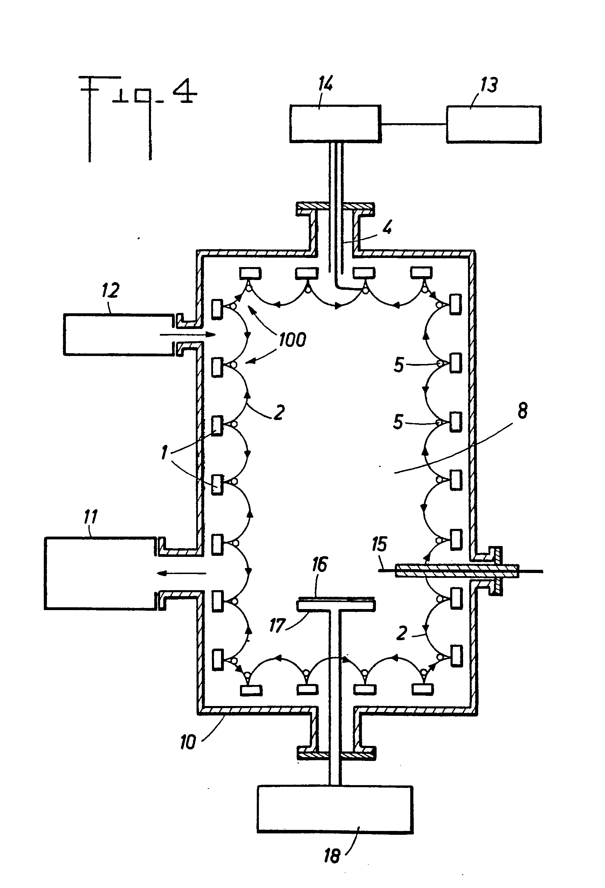

A titre d'exemple, on a représenté sur les fig. 1, 4 et 5, une structure multipolaire de confinement 100, constituée de barres 1, d'aimants permanents parallèles présentant successivement au plasma des polarités alternées, comme indiqué sur la fig. 1, de façon à constituer une surface magnétique fermée. Le plasma est ainsi confiné dans la zone 8, à l'intérieur des festons de lignes de champs magnétiques 2 représentés de façon schématique sur les fig. 1 et 4. Une telle structure 100 est également caractérisée par un réseau de surface à champs magnétiques constants, avec parmi elles, une surface 3 dont l'intensité correspond à la résonance cyclotronique électronique. Cette surface 3 enveloppe chaque paroi aimantée, comme représenté en pointillé sur la fig. 1, ainsi que sur les fig. 3a et 3b.

La résonance cyclotronique électronique nécessite l'usage d'aimants permanents 1 délivrant une intensité de champ magnétique suffisante à une distance convenable, de l'ordre de quelques millimètres, des pôles magnétiques. On peut utiliser pour cela, en particulier, des aimants en ferrite de baryum ($B_1O$, $6 Fe_2O_3$) ou de strontium, ou des aimants en samarium cobalt ($SmCo_5$).

Comme on l'a indiqué précédemment, la puissance microondes doit être introduite à l'intérieur de la cage multipolaire 100 et l'énergie associée doit être localisée près de la zone de résonance. Pour cela, on utilise un câble coaxial 4 ou une structure coaxiale équivalente, ou encore un guide d'ondes, à l'intérieur desquels la puissance micro-ondes est véhiculée. Par ailleurs, la puissance est injectée dans la zone de résonance au moyen d'une antenne 5 qui peut être couplée directement au guide d'ondes, ou qui prolonge l'âme centrale 41 du câble coaxial 4, comme indiqué schématiquement sur la fig. 2. L'antenne 5 est positionnée pour être située au moins à proximité de la surface 3 selon tout arrangement possible par rapport à la barre 1. Cette antenne peut ainsi être disposée perpendiculairement. Une position particulièrement efficace, comme représenté sur les fig. 2, 3a et 3b, consiste à placer l'antenne 5 tout au long d'une barre aimantée 1, à l'intersection du plan médian de celle-ci et de la surface 3 à champ magnétique constant et d'intensité correspondant à la résonance cyclotronique électronique. Ainsi, on assure un meilleur confinement de l'énergie électromagnétique entre l'antenne et le plan de masse, ce qui évite la présence de champs électro-magnétiques périodiques dans la zone 8.

Les modes de réalisation de l'invention peuvent être très variés. Ainsi, la cage multipolaire 100 peut être parallélépipédique, comme représenté sur la fig. 4, cylindrique, comme représenté sur les fig. 1 et 5, elliptique, sphérique ou encore présenter d'autres formes géométriques. Il est également possible d'utiliser une ou plusieurs antennes 5 et, dans ce dernier cas, les antennes 5 peuvent être, soit réparties régulièrement sur la surface 2 de confinement, soit réparties de façon dissymétrique, leur nombre étant adapté à la densité de plasma maximale à atteindre.

Dans certains cas, le niveau de puissance micro-ondes en volume, une fois le plasma excité, peut rester gênant pour l'application envisagée. Il est alors possible, comme représenté sur la fig. 1, d'interposer, entre la zone externe d'excitation du plasma 7 et la zone centrale d'utilisation 8, une grille métallique 9 faisant office de cage de FARADAY. Le potentiel de cette grille 9 doit être fixé afin d'éviter des fluctuations. Si le pas de la grille 9 est faible devant la longueur d'ondes hyperfréquences et grande devant la longueur de DEBYE du plasma, la diffusion de ce dernier s'effectue sans difficulté, alors que le rayonnement hyperfréquence reste confiné dans la zone d'excitation.

Le champ magnétique délivré par les aimants permanents 1 peut également être accru, si l'on referme le circuit magnétique à l'extérieur de la cage 100, soit avec des aimants permanents, soit encore avec un matériau de grande perméabilité 10, tel que du fer doux, qui peut être intégré dans la réalisation de l'enceinte à vide (voir fig. 1 et 4). Cette mesure permet de supprimer l'effet antagoniste du pôle opposé de chaque barre aimantée et d'accroître ainsi le champ magnétique près de la surface du pôle actif situé en regard de la zone d'utilisation 8.

Les aimants permanents 1 peuvent être très sensibles aux effets de température. Afin d'éviter l'absorption directe de l'énergie micro-ondes par les aimants 1, il peut être utile, sinon de les refroidir, du moins de les recouvrir, du côté de la surface orientée vers l'antenne 5 et le plasma, d'un matériau métallique, de préférence amagnétique. De même, afin d'éviter l'appauvrissement du plasma en électrons, il est possible d'isoler par un diélectrique l'antenne 5, l'arrivée de gaz et la partie de la structure multipolaire 100 en contact direct avec le plasma.

Il est, par ailleurs, avantageux de refroidir, par une circulation de fluide, l'antenne 5 et l'âme centrale du câble coaxial 4 permettant l'introduction de l'énergie dans la cage multipolaire 100 et sa répartition sur la surface de celle-ci. Ceci est d'autant plus nécessaire sous vide partiel, que le refroidissement ne peut a'effectuer que par conduction ou rayonnement. Suivant le diamètre de l'antenne utilisée, ce refroidissement peut s'effectuer, soit par simple écoulement à l'intérieur de l'antenne, soit par double écoulement en utilisant une structure coaxiale interne à l'antenne 5. L'avantage du refroidissement est qu'il permet d'accroître sans risque la puissance micro-ondes injectée et donc la densité du plasma.

Une autre caractéristique de la présente invention réside dans la possibilité d'introduction du gaz à ioniser au niveau même de l'antenne 5. Si l'antenne n'est pas refroidie, elle peut servir directement à la distribution du gaz, qui circule alors à l'intérieur de celle-ci. Si l'antenne est refroidie, ce qui est généralement le cas, la distribution de gaz peut être effectuée par un autre tube 6 qui peut être, soit accolé à l'antenne elle-même (fig. 3a), soit situé dans son voisinage proche (fig. 3b). Pour une répartition régulière des gaz, le tube d'amenée de gaz 6 est percé, sur toute sa longueur, de multiples orifices de diamètres assez petits devant le diamètre intérieur du tube 6. Avec un tel mode de distribution du gaz, la pression de gaz est maximale au niveau même de l'excitation et minimale dans le volume central du plasma.

Le schéma de la fig. 4 montre, en coupe transversale, un dispositif complet de production de plasma mettant en oeuvre la présente invention. Ce dispositif comporte une enceinte étanche 10, magnétique ou amagnétique, des dispositifs de pompage 11 et d'introduction de gaz 12 permettant de maintenir la pression du gaz à ioniser à la valeur désirée, qui peut être, par exemple, de l'ordre de $10^{-3}$ à $10^{-1}$ Pascals. La structure multipolaire magnétique de confinement 100 est formée d'aimants permanents 1 donnant, près de la structure, un champ magnétique suffisant pour obtenir une résonance cyclotronique électronique, comme cela a été indiqué plus haut. La puissance micro-ondes fournie par un générateur 13 est introduite dans l'enceinte 10, puis dans la cage multipolaire 100, par un câble coaxial 4, qui pourrait être toutefois remplacé par un guide d'ondes. L'accord est obtenu par un adaptateur d'impédance 14, pouvant être constitué par exemple par un "T" hybride. L'excitation du plasma est obtenue dans la zone de résonance, grâce aux antennes 5 réparties sur au moins une partie de la surface magnétique de confinement. Le plasma obtenu peut être caractérisé par un dispositif, tel qu'une sonde de LANGMUIR 15. Le plasma permet, dans la zone d'utilisation 8, un traitement de surface. L'échantillon 16 est placé sur un porteéchantillon 17 par un sas d'introduction, non représenté sur les dessins, et polarisé par rapport au potentiel du plasma, grâce à un générateur 18. Cette polarisation est totalement indépendante des paramètres de production et de confinement du plasma.

A titre d'exemple, il a été possible d'obtenir des densités de $10^{11}$ par $cm^3$ à une fréquence de 2,45 GHz et de $10^{12}$ par $cm^3$ à une fréquence de 10,0 GHz.

A titre d'exemple, dans un réacteur multipolaire de 15 litres de volume utile, utilisant des aimants permanents en ferrite de baryum et une excitation à 2,45 GHz, avec une antenne simple de 15 cm de long, il a été possible d'obtenir une pression de $10^{-1}$ Pascals, un plasma d'argon de densité n = 3 × $10^{10}$ $cm^3$ avec une puissance micro-onde injectée de 100 watts. Dans ce cas, la température électronique est de l'ordre de 18 000 K (1,6 électronvolt). Avec trois antennes réparties sur la surface, on obtient une densité proche de $10^{11}$ $cm^3$.

Parmi les différents avantages de la présente invention, on peut noter la possibilité d'augmenter la densité du plasma à l'intérieur de la structure de confinement multipolaire par simple accroissement de la surface de la source micro-ondes, c'est-à-dire de la longueur de l'antenne. La densité du plasma peut, en outre, être augmentée par simple augmentation de la fréquence micro-ondes de travail et donc de la densité critique.

Un autre avantage réside dans l'absence de structures magnétiques spéciales supplémentaires, telles que bobines qui sont toujours coûteuses et encombrantes et impliquent une alimentation et un système de refroidissement. L'absence de bobine d'électroaimants élimine également la présence de champs magnétiques intenses résiduels dans la zone 8.

Dans le cas où l'on utilise la localisation simultanée de la zone de résonance cyclotronique électronique, de la puissance micro-ondes et de la distribution de gaz, il est possible d'obtenir des plasmas à très basse pression, jusqu'à $10^{-3}$ Pascals, au coeur du volume de confinement.

Si les antennes sont réparties sur la surface de confinement, l'homogénéité du plasma est améliorée, y compris aux fortes pressions de l'ordre de $10^{-1}$ Pascals où les collisions ne peuvent plus être négligées.

Dans le cas où l'on utilise des câbles coaxiaux, le transport d'énergie micro-ondes est peu coûteux et facile à intégrer dans une machine. Il permet, de plus, de réaliser des structures de confinement parfaitement fermées.

On peut noter, également, que la structure du dispositif selon l'invention autorise diverses applications. En l'absence de plasma, la puissance micro-ondes introduite dans le réacteur peut permettre un dégazage très efficace de l'intérieur de l'enceinte 10, facilitant, notamment, l'élimination des traces de vapeur d'eau, particulièrement gênante avec les plasmas fluorés et les plasmas chlorés.

On a décrit, en référence aux fig. 1, 4 et 5, le cas de la production d'un plasma et de son confinement dans une structure multipolaire unique et fermée. Pour certaines applications, pour lesquelles les exigences sur le confinement et l'uniformité du plasma sont moins strictes, il est possible d'utiliser un dispositif d'excitation conforme à l'invention, par exemple avec des associations de barre et d'antenne, tel que représenté sur les fig. 2, 3a et 3b, pour la seule génération du plasma. Les différents aimants peuvent aussi être disposés sur une structure non fermée où les seuls impératifs sont liés à l'introduction du plasma et non à son confinement. Dans ce cas, les contraintes sur la disposition des aimants sont moins rigoureuses et, par exemple, la,non alternance des pôles magnétiques peut être tolérée. Un tel dispositif est bien adapté à la réalisation de sources de plasma de grandes dimensions, par exemple des tunnels à plasma et à la production d'ions.

## Revendications

1. Dispositif d'excitation d'un plasma par micro-ondes à la résonance cyclotronique électronique, comportant au moins un aimant permanent (1), caractérisé en ce que l'aimant permanent (1) crée une surface (3) à champ magnétique constant d'intensité correspondant à la résonance cyclotronique électronique et en ce qu'il comporte au moins une antenne (5) raccordée à une structure coaxiale (4) d'application d'énergie dans le domaine des micro-ondes et positionnée au moins à proximité de ladite surface (3) à champ magnétique constant et d'intensité correspondant à la résonance cyclotronique électronique.

2. Dispositif selon la revendication 1, caractérisé en ce que l'aimant permanent (1) est constitué par une barre aimantée et en ce que l'antenne (5) est positionnée à l'intersection du plan médian de ladite barre et de la surface (3) à champ magnétique constant et d'intensité correspondant à la résonance cyclotronique électronique.

3. Dispositif selon la revendication 1 ou 2, caractérisé en ce qu'il comprend, en outre, des moyens de circulation d'un fluide de refroidissement le long de l'antenne (5).

4. Dispositif selon l'une quelconque des revendications 1 à 3, caractérisé en ce qu'il comprend, en outre, des moyens (6) d'amenée de gaz à ioniser disposés à proximité immédiate de l'antenne (5) et percés d'orifices répartis le long de ladite antenne (5).

5. Dispositif selon l'une quelconque des revendications 1 à 4, caractérisé en ce que ladite structure coaxiale (4) est constituée par un câble coaxial.

6. Dispositif de production d'un plasma dense, de grand volume, de bonne homogénéité, isotrope et exempt de champs, comprenant une enceinte étanche (10) raccordée à un circuit de pompage (11) et à un circuit (12) d'apport d'un milieu gazeux pour maintenir une pression déterminée dans l'enceinte, une structure (100) de confinement magnétique multipolaire et un dispositif d'excitation par micro-ondes du milieu gazeux à la résonance cyclotronique électronique,

caractérisé en ce que le dispositif d'excitation par micro-ondes comprend au moins une structure coaxiale (4) pour l'introduction de la puissance micro-ondes à l'intérieur de la structure de confinement multipolaire et au moins une antenne (5) couplée à la structure coaxiale (4) pour l'introduction localisée de l'énergie micro-ondes, en ce que la structure de confinement magnétique multipolaire (100) comprend une série d'aimants permanents (1) créant un réseau de surface (3) à champ magnétique constant et présentant localement une intensité correspondant à la résonance cyclotronique électronique, et en ce que ladite antenne (5) est positionnée sur ledit réseau de surfaces à champ magnétique constant dans une zone d'intensité correspondant à la résonance cyclotronique électronique.

7. Dispositif selon la revendication 5, caractérisé en ce que la structure de confinement magnétique multipolaire (100) est constituée par une cage multipolaire formée par des barres (1) à caractère magnétique permanent s'étendant parallèlement entre elles et offrant, en direction du volume que la structure de confinement délimite, une face de polarité successivement différente, et en ce que l'antenne (5) est disposée parallèlement à une barre magnétique (1), à l'intersection du plan médian de la barre et de la surface (3) à champ magnétique constant et d'intensité correspondant à la résonance cyclotronique électronique.

8. Dispositif selon la revendication 6 ou 7, caractérisé en ce que le dispositif d'excitation par micro-ondes comprend plusieurs antennes (5) réparties le long de la structure de confinement magnétique multipolaire (100).

9. Dispositif selon l'une quelconque des revendications 6 à 8, caractérisé en ce que la structure de confinement magnétique multipolaire (100) est disposée à l'intérieur de l'enceinte étanche (10).

10. Dispositif selon l'une quelconque des revendications 6 à 9, caractérisé en ce que la structure de confinement magnétique multipolaire (100) formant cage est associée à une structure de fermeture du circuit magnétique à l'extérieur de la cage et en ce que ladite structure de fermeture comprend des aimants permanents ou un matériau de grande perméabilité.

11. Dispositif selon la revendication 10, caractérisé en ce que ladite structure de fermeture, réalisée en un matériau de grande perméabilité, est intégrée dans l'enceinte étanche (10).

12. Dispositif selon l'une quelconque des revendications 6 à 11, caractérisé en ce qu'il comprend, au moins, un tube (6) d'introduction de gaz à ioniser, situé au voisinage immédiat de chaque antenne (5), parallèlement à celle-ci, et en ce que chaque tube (6) est percé d'un ensemble d'orifices répartis sur sa longueur et présentant un diamètre faible par rapport au diamètre du tube (6).

13. Dispositif selon l'une quelconque des revendications 6 à 11, caractérisé en ce qu'il comprend, en outre, des moyens pour faire circuler dans l'antenne (5) un fluide de refroidissement ou un flux de gaz à ioniser.

14. Procédé d'excitation d'un plasma par micro-ondes à la résonance cyclotronique électronique, pour la production d'un plasma dense, de grand volume, de bonne homogénéité, isotrope et exempt de champs,

caractérisé en ce qu'il consiste à produire localement, à l'aide d'une structure magnétique multipolaire, un champ magnétique d'intensité suffisante pour la résonance cyclotronique électronique et à introduire à l'aide d'antennes l'énergie micro-ondes de façon localisée dans la zone de champ magnétique permettant la résonance cyclotronique électronique.

## Patentansprüche

1. Vorrichtung zur Anregung eines Plasmas mittels Mikrowellen an der Elektronen-Zyklotron-Resonanz mit zumindest einem Dauermagneten (1), dadurch gekennzeichnet, daß der Dauermagnet (1) eine Fläche (3) eines in seiner Intensität konstanten Magnetfeldes entsprechend der Elektronen-Zyklotron-Resonanz erzeugt und dadurch, daß sie zumindest eine Antenne (5), die an eine koaxiale Struktur (4) zur Einspeisung von Energie in den Bereich der Mikrowellen angeschlossen ist, wobei sie zumindest in der Nähe der Fläche (3) eines konstanten magnetischen Feldes, dessen Intensität der Elektronen-Zyklotron-Resonanz entspricht, angebracht ist.

2. Vorrichtung nach Anspruch 1, dadurch gekennzeichnet, daß der Dauermagnet (1) durch einen dauermagnetischen Block gebildet ist und dadurch, daß die Antenne (5) am Schnittpunkt der Mittenebene des Blockes mit der Fläche (3) eines konstanten magnetischen Feldes, dessen Intensität der Elektronen-Zyklotron-Resonanz entspricht, angebracht ist.

3. Vorrichtung nach Anspruch 1 oder 2, dadurch gekennzeichnet, daß sie außerdem Mittel zur Zirkulation einer Kühlflüssigkeit längs der Antenne (5) aufweist.

4. Vorrichtung nach einem der Ansprüche 1 bis 3, dadurch gekennzeichnet, daß sie außerdem Mittel (6) zum Zuliefern des zu ionisierenden Gases aufweist, die in nächster Nähe der Antenne (5) angebracht sind und die von Öffnungen, die längs der Antenne (5) angebracht sind, durchstoßen sind.

5. Vorrichtung nach einem der Ansprüche 1 bis 4, dadurch gekennzeichnet, daß die koaxiale Struktur (4) durch ein Koaxialkabel gebildet wird.

6. Vorrichtung zum Erzeugen von dichtem Plasma in großer Menge, guter Homogenität, isotrop und feldfrei mit einem luftdichten Behälter (10), der an einen Pumpkreis (11) und an einen Kreis (12) zum Zuliefern eines gasförmigen Mediums, um einen vorbestimmten Druck innerhalb des Behälters aufrecht zu erhalten, angeschlossen ist, einer multipolaren, magnetischen einschließenden Struktur (100) und einer Vorrichtung zum Anregen des gasförmigen Mediums mit Mikrowellen an der Elektronen-Zyklotron-Resonanz,

dadurch gekennzeichnet, daß die Vorrichtung zur Anregung mit Mikrowellen zumindest eine koaxiale Struktur zur Einleitung von Mikrowellenenergie in das Innere der multipolaren einschließenden Struktur aufweist sowie zumindest eine an die koaxiale Struktur (4) angeschlossene Antenne (5) zum örtlich definierten Einleiten der Mikrowellenenergie, dadurch, daß die multipolare, magnetische einschließende Struktur (100) eine Reihe von Dauermagneten (1) aufweist, die ein Netzwerk von Flächen (3) mit konstantem magnetischen Feld erzeugen und das lokal eine Intensität entsprechend der Elektronen-Zyklotron-Resonanz aufweist, und dadurch, daß die Antenne (5) an der gitterförmigen Fläche eines konstanten magnetischen Feldes in derjenigen Zone angebracht ist, deren Intensität der Elektronen-Zyklotron-Resonanz entspricht.

7. Vorrichtung nach Anspruch 5, dadurch gekennzeichnet, daß die multipolare, magnetische, einschließende Struktur (100) durch einen multipolaren Käfig gebildet wird, der durch dauermagnetische Blöcke (1) geformt wird, die sich untereinander parallel und in Richtung des Volumens erstrecken, das die einschließende Struktur begrenzt, die abwechselnd unterschiedliche Oberflächenpolaritäten zeigen, und dadurch, daß die Antenne (5) parallel zu einem magnetischen Block (1) am Schnittpunkt der Mittenebene des Blockes mit der Fläche (3) eines konstanten magnetischen Feldes einer der Elektronen-Zyklotron-Resonanz entsprechenden Intensität angebracht ist.

8. Vorrichtung nach Anspruch 6 oder 7, dadurch gekennzeichnet, daß die Vorrichtung zur Anregung mit Mikrowellen mehrere über die Länge der multipolaren, magnetischen einschließenden Struktur (100) verteilte Antennen (5) aufweist.

9. Vorrichtung nach einem der Ansprüche 6 bis 8, dadurch gekennzeichnet, daß die multipolare, magnetische, einschließende Struktur (100) im Inneren des luftdichten Behälters (10) angebracht ist.

10. Vorrichtung nach einem der Ansprüche 6 bis 9, dadurch gekennzeichnet, daß die einen Käfig bildende multipolare, magnetische, einschließende Struktur (100) mit einer Struktur verbunden ist, die außerhalb des Käfigs den magnetischen Kreis schließt und dadurch, daß diese schließende Struktur Dauermagneten oder ein Material hoher Permeabilität aufweist.

11. Vorrichtung nach Anspruch 10, dadurch gekennzeichnet, daß die schließende Struktur, die aus einem Material hoher Permeabilität gebildet ist, im luftdichten Behälter (10) integriert ist.

12. Vorrichtung nach einem der Ansprüche 6 bis 11, dadurch gekennzeichnet, daß sie zumindest ein Rohr (6) zur Einleitung des zu ionisierenden Gases aufweist, das in nächster Nähe einer jeden Antenne (5) und parallel zu ihr angebracht ist, und dadurch, daß jedes Rohr (6) von einer Anordnung von sich über dessen Länge erstreckenden Öffnungen durchstoßen ist, die in bezug auf den Durchmesser des Rohres (6) einen kleinen Durchmesser aufweisen.

13. Vorrichtung nach einem der Ansprüche 6 bis 11, dadurch gekennzeichnet, daß sie außerdem Mittel zur Verursachung einer Zirkulation einer Kühlflüssigkeit an der Antenne (5) oder eines Flusses des zu ionisierenden Gases aufweist.

14. Verfahren zur Anregung eines Plasmas mit Mikrowellen an der Elektronen-Zyklotron-Resonanz zur Erzeugung eines dichten Plasmas in großer Menge und guter Homogenität, isotrop und feldfrei, gekennzeichnet durch die lokale Erzeugung mit Hilfe einer multipolaren, magnetischen Struktur eines magnetischen Feldes, dessen Stärke für die Elektronen-Zyklotron-Resonanz genügt und durch die Einleitung von Mikrowellenenergie mit Hilfe von Antennen im Bereich der Magnetfeldzone, die die Elektronen-Zyklotron-Resonanz erlauben.

## Claims

1. Device for exciting a plasma by using microwaves at the electronic cyclotronic resonance, comprising at least one permanent magnet (1), characterized in that the permanent magnet (1) creates a surface (3) of constant magnetic field and of intensity corresponding to the electronic cyclotronic resonance, and in that it comprises at least one antenna (5) joined to a co-axial structure (4) for applying energy in the microwave range, and positioned on at least close to said surface (3) of constant magnetic field and of intensity corresponding to the electronic cyclotronic resonance.

2. Device according to claim 1, characterized in that the permanent magnet (1) is constituted by a magnetized bar and in that the antenna (5) is positioned at the intersection of the median plane of said bar with the surface (3) having a constant magnetic field and an intensity corresponding to the electronic cyclotronic resonance.

3. Device according to claim 1 or 2, characterized in that it further comprises means for creating a flow of cooling fluid along the antenna (5).

4. Device according to any one of claims 1 to 3, characterized in that it further comprises means (6) for admitting the gas to be ionized, which means are provided immediately close to the antenna (5) and are perforated with orifices distributed along said antenna (5).

5. Device according to any one of claims 1 to 4, characterized in that said co-axial structure (4) is constituted by a co-axial cable.

6. Device for producing a high density, large volume homogeneous, isotropic and field-free plasma, comprising a tight enclosure (10) connected to a pumping circuit (11) and to a circuit (12) for introducing a gaseous medium, said circuit keeping up a predetermined pressure inside the enclosure, a multipolar magnetic confinement structure (100), and a device for exciting the gaseous medium by way of microwaves at the electronic cyclotronic resonance, characterized in that said microwaves excitation device comprises at least one co-axial structure (4) for introducing the microwave power inside the multipolar confinement structure and at least one antenna (5) coupled to the co-axial structure (4) for localized introduction of the microwave energy, in that the multipolar magnetic confinement structure (100) comprising a series of permanent magnets (1) creating a network of surfaces (3) having a constant magnetic field and presenting locally an intensity which corresponds to the electronic cyclotronic resonance, and in that said antenna (5) is positioned on said network of surfaces of constant magnetic field in an area of intensity corresponding to the electronic cyclotronic resonance.

7. Device according to claim 5, characterized in that the multipolar magnetic confinement structure (100) is constituted by a multipolar cage formed by bars (1) of permanent magnetic type which bars extend in parallel and offer, in the direction of the volume defined by the confinement structure, a face of successively different polarities and in that the antenna (5) is placed in parallel to a magnetic bar (1), at the intersection of the median plane of the bar and of the surface (3) of a constant magnetic field and, of intensity corresponding to the electronic cyclotronic resonance.

8. Device according to claim 6 or 7, characterized in that said microwave excitation device comprises a plurality of antennas (5) distributed along the multipolar magnetic confinement structure (100).

9. Device according to any one of claims 6 to 8, characterized in that said multipolar magnetic confinement structure (100) is placed inside the tight enclosure (10).

10. Device according to any one of claims 6 to 9, characterized in that said multipolar magnetic confinement structure (100) forming cage is operationally coupled to a structure ensuring the closure of the magnetic circuit outside the cage, and in that said closing structure comprises permanent magnets or a highly permeable material.

11. Device according to claim 10, characterized in that said closing structure, produced from a highly permeable material, is integrated in the tight enclosure (100).

12. Device according to any one of claims 6 to 11, characterized in that it comprises at least one tube (6) for introducing the gas to be ionized, situated immediately close to each antenna (5) and parallel to said antenna, and in that each tube (6) is provided with a set of orifices distributed throughout its length and having a small diameter compared with the diameter of the tube (6).

13. Device according to any one of claims 6 to 11, characterized in that it further comprises means for creating inside the antenna (5) a flow of cooling fluid or of gas to be ionized.

14. Method for exciting a plasma using microwave at the electronic cyclotronic resonance, for producing a high density, large volume homogeneous, isotropic and field-free plasma, characterized in that said method consists in producing locally, by means of a multipolar magnetic structure, a magnetic field of sufficient intensity for the electronic cyclotronic resonance, and in introducing the microwaves energy in localized manner, via antennas, in the zone of magnetic fields permitting an electronic cyclotronic resonance.

Fig.2

Fig.3a

Fig.3b

Fig.5

Fig. 4